# EUROPÄISCHE PATENTSCHRIFT

(11) **EP 2 843 713 B1**
(45) Veröffentlichungstag und Bekanntmachung des Hinweises auf die Patenterteilung: **04.11.2020**
(21) Anmeldenummer: 14183173.5
(22) Anmeldetag: 02.09.2014
(51) Int. Cl.: H01L 31/18, H01L 21/67, H01L 21/304

(54) **Vorrichtung und Verfahren zur Herstellung eines Wafers mit einer Rissverlaufsbeeinflussung**
Device and method for the manufacture of a wafer with influence of a crack line
Dispositif et procédé de fabrication d'un wafer doté d'une influence de forme de la fissure

(30) Priorität: 02.09.2013 DE 102013014615
(43) Veröffentlichungstag der Anmeldung: 04.03.2015
(73) Patentinhaber: Siltectra GmbH, 01099 Dresden (DE)
(72) Erfinder: Lichtensteiger, Lukas, 8037 Zürich (CH); Richter, Jan, 01277 Dresden (DE); Ajaj, Anas, 01069 Dresden (DE)
(74) Vertreter: Westphal, Mussgnug & Partner Patentanwälte mbB

(56) Entgegenhaltungen:
- EP-A1- 2 620 409
- US-A1- 2012 234 887
- US-A1- 2012 322 227
- US-A1- 2012 322 228

## Beschreibung

Die vorliegende Erfindung bezieht sich auf ein Verfahren zur Herstellung von Festkörperschichten, auf einen gemäß dem Verfahren hergestellten Wafer und auf eine Vorrichtung zum Herstellen von Festkörperschichten.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafer für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird. Ein ähnliches Verfahren zum Erzeugen dünner Wafer ist in US 2012/234887 A1 beschrieben.

Die Polymerschicht weist bei den erwähnten Verfahren einen im Vergleich zum Werkstück um ungefähr zwei Größenordnungen höheren thermischen Ausdehnungskoeffizienten auf. Außerdem kann durch Ausnutzen eines Glasübergangs ein relativ hohes Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen.

Bei Verwendung der Verfahren nach bisherigem Stand der Technik weisen die hergestellten Wafer üblicherweise jeweils größere Dickenschwankungen auf. Die totale Dickenschwankung über den ganzen Wafer gesehen ("total thickness variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet bzw. führen die Dickenschwankungen bei der Weiterverarbeitung des Wafers zu Problemen oder Wirkungsgradeinbußen. Außerdem liegen bei den am häufigsten auftretenden Dickenverteilungsmustern die Bereiche mit den größten Schwankungen ungünstigerweise in der Mitte des Wafers, wo sie am meisten stören.

Außerdem entstehen bei den Verfahren nach aktuellem Stand der Technik insbesondere in der Nähe des Waferrandes auf der Waferoberfläche relativ ausgedehnte Bereiche mit signifikant größerer Rauheit. Dies führt dazu, dass diese Randbereiche für viele Anwendungen nicht nutzbar sind. Außerdem erschweren diese rauen Stellen die Weiterverarbeitung des ganzen Wafers und können sogar zum späteren Zerbrechen des Wafers führen.

Es ist somit Aufgabe der vorliegenden Erfindung ein Verfahren und eine Vorrichtung zur Herstellung von Festkörperschichten und/oder Festkörperplatten bereitzustellen, welche/s die Qualität der hergestellten Festkörperschichten bzw. Festkörperplatten gegenüber den bekannten Verfahren verbessert, insbesondere soll die Rauheit in den Festkörperrandbereichen verringert und/oder eine gleichmäßigere Schichtdicke der gesamten Festkörperschichten und/oder Festkörperplatten erzeugt werden.

Diese zuvor genannte Aufgabe wird durch ein Verfahren zur Herstellung von Festkörperschichten und/oder Platten, insbesondere zur Verwendung als Wafer, gemäß Anspruch 1 gelöst. Das erfindungsgemäße Verfahren umfasst dabei bevorzugt die folgenden Schritte:
Bereitstellen mindestens eines Werkstücks zum Ablösen der Festkörperschichten, wobei das Werkstück zumindest eine erste und zweite exponierte Oberflächen aufweist, wobei sich zumindest die erste exponierte Oberfläche in einer X-Y-Ebene erstreckt und die zweite exponierte Oberfläche bevorzugt ebenfalls in einer X-/Y-Ebene erstreckt, Erzeugen und/oder Bereitstellen einer Aufnahmeschicht zum Halten der Festkörperschicht, zumindest abschnittsweises Verbinden der Aufnahmeschicht mit der ersten exponierten Oberflächen des Werkstücks unter Bildung einer Kompositstruktur, und Erzeugen und/oder Bereitstellen einer Stabilisierungsschicht zum Halten des Werkstücks, zumindest abschnittsweises Verbinden der Stabilisierungsschicht mit der zweiten exponierten Oberflächen des Werkstücks und mit der Aufnahmeschicht unter Bildung eines Verbindungsbereichs, wobei mindestens ein Anteil der Aufnahmeschicht in dem mit der Stabilisierungsschicht verbundenen Verbindungsbereich einen vorgegebenen Formanteil aufweist, Beaufschlagen der Kompositstruktur mit einem inneren und/oder äußeren Spannungsfeld in der Art, dass die Festkörperschicht entlang einer sich innerhalb des Werkstücks erstreckenden Ebene durch eine Rissausbreitung von dem Werkstück abgelöst wird, wobei durch die Form der Aufnahmeschicht im Verbindungsbereich die Rissausbreitung innerhalb des Werkstücks definiert beeinflusst wird.

Beispiele solcher vorgegebenen Formen bzw. vordefinierten Geometrien sind ein rechteckiger Abschnitt angrenzend an eine gerade Kante eines pseudo-quadratischen Wafers oder zwei oder mehrerer solcher rechteckige Abschnitte angrenzend an benachbarte oder gegenüberliegende gerade Kanten eines pseudo-quadratischen Wafers, wobei beispielsweise durch geeignete Wahl der Fläche dieser rechteckigen Abschnitte in der Waferebene und insbesondere deren Breite, senkrecht zur Waferkante gesehen, die Haftung zwischen Ablöseschicht und Aufnahmeschicht lokal beeinflusst und die Dynamik des Ablösens bestimmt werden kann. Insbesondere wird durch rechteckige Abschnitte größerer Breite der Prozess des Ablösens lokal stärker verlangsamt als durch rechteckige Abschnitte kleinerer Breite. Außerdem ist es möglich, diese Breite lokal so groß zu wählen, dass in diesem Abschnitt lokal kein Ablösen mehr stattfindet, so dass der Prozess des Ablösens also lokal gestoppt wird. Ein weiteres Beispiel einer solchen vordefinierten Geometrie ist eine Abfolge von jeweils einem solchen rechteckigen Abschnitt großer Breite gefolgt jeweils von einem rechteckigen Abschnitt kleiner Breite, so dass die Haftung zwischen Ablöseschicht und Aufnahmeschicht räumlich definiert schwankt und beim Ablösen ein Effekt entsteht wie beim Aufreißen einer Perforation. Selbstverständlich kann die Haftung zwischen Ablöseschicht und Aufnahmeschicht lokal aber auch durch andere geeignete Verfahren, insbesondere die Auswahl und Anwendung von verschiedenen Klebemethoden, entsprechend gezielt beeinflusst werden. Die vorliegende Erfindung stellt somit eine Lösung bereit, mittels der die Rissausbreitung innerhalb eines Werkstücks steuerbar ist, wodurch z.B. geringere Dickenschwankungen erzielbar sind.

Gemäß einer bevorzugten Ausführungsform der vorliegenden Erfindung wird mindestens ein Anteil der Aufnahmeschicht, der eine vorgegebene Form aufweist, in der Rissausbreitungsebene angeordnet und der mindestens eine Anteil der Aufnahmeschicht wird in X- und/oder Y-Richtung zu der ersten Oberfläche beabstandet angeordnet.

Diese Ausführungsform ist vorteilhaft, da die Oberfläche des definierten Anteils der Aufnahmeschicht die erste Oberfläche des Werkstücks nicht überlagert, sondern seitlich davon ausgebildet, angeordnet oder erzeugt wird. Durch die voneinander beabstandeten Positionen des definierten Anteils und der ersten Oberfläche sind die sich durch die geometrische Form des ersten Anteils auf die Rissausbreitung auswirkenden Eigenschaften vorteilhaft nutzbar.

Die Aufnahmeschicht weist gemäß einer weiteren bevorzugten Ausführungsform der vorliegenden Erfindung eine erste Außenkante und eine zweite Außenkante, die zueinander bevorzugt im Wesentlichen oder genau parallel ausgerichtet sind, und mindestens eine weitere, insbesondere eine dritte, Außenkanten, die gegenüber der ersten und der zweiten Außenkante geneigt angeordnet ist, auf, wobei die erste, zweite und dritte Außenkante sich in der X-Y-Ebene erstrecken und an einer der drei Außenkanten der Anteil der Aufnahmeschicht mit der vorgegebenen Form ausgebildet ist und an zumindest einer der beiden anderen Außenkanten ein weiterer Anteil zum Beeinflussen der Rissausbreitung mit einer vorgegebenen Form ausgebildet ist.

Diese Ausführungsform ist vorteilhaft, da mittels zweier geometrisch definierter Anteile der Rissverlauf im Werkstück noch genauer steuerbar ist. Die sich dadurch ergebenden Festkörperschichtdicken haben eine reproduzierbare und im Vergleich zum Stand der Technik deutlich homogenere Dicke.

Gemäß einer weiteren bevorzugten Ausführungsform der vorliegenden Erfindung ist an der zweiten Außenkante und an der dritten Außenkante jeweils ein weiterer Anteil zum Beeinflussen der Rissausbreitung mit einer vorgegebenen Form ausgebildet, wobei die an der ersten Außenkante, der zweiten Außenkante und der dritten Außenkante ausgebildeten Anteile in ihrer Gesamtheit bevorzugt eine U-förmige Anordnung darstellen. Es ist jedoch ebenfalls denkbar, dass die weiteren Anteile nur einen Bruchteil des Volumens und/oder der Oberfläche des ersten definierten Anteils der Aufnahmeschicht aufweisen. Bevorzugt weist mindestens ein weiterer Anteil der Aufnahmeschicht eine Oberfläche auf, deren Gesamtfläche weniger als die Hälfte oder weniger als ein Viertel oder weniger als ein Achtel der Oberfläche des ersten Anteils beträgt. Die unterschiedlich groß ausgebildeten Anteile beeinflussen dabei die Rissausbereitung auf unterschiedliche Weise, insbesondere bewirken einzelne Anteile ein Stoppen der Rissausbreitung und andere Anteile ein Abbremsen der Rissausbreitung.

Innerhalb des Anteils der Aufnahmeschicht, in dem die Aufnahmeschicht mit der Stabilisierungsschicht verbundenen ist und eine vorgegebene Form aufweist, ist gemäß einer weiteren bevorzugten Ausführungsform der vorliegenden Erfindung ein Strukturelement, insbesondere in Form eines Metallstücks oder mehrerer Metallstücke, zur Veränderung der Eigenschaften des mit einer vorgegebenen Form ausgebildeten Anteils der Aufnahmeschicht in die Aufnahmeschicht eingebracht ist, wobei das Strukturelement bevorzugt aus einem Material besteht, das von dem Material der Aufnahmeschicht verschieden ist. Diese Ausführungsform ist vorteilhaft, da die Eigenschaften der Aufnahmeschicht, die bevorzugt aus einem Polymer, insbesondere PDMS, besteht, durch mindestens oder genau ein, mindestens oder genau zwei, mindestens oder genau drei, mindestens oder genau vier, mindestens oder genau fünf oder mehrere zusätzliche eingebrachte Elemente lokal anpassbar sind, wodurch der Rissverlauf beeinflussbar bzw. reproduzierbar steuerbar ist.

Gemäß einer weiteren bevorzugten Ausführungsform der vorliegenden Erfindung weist die Aufnahmeschicht in mindestens einem vorbestimmten Bereich einen E-Modul auf, der gegenüber dem E-Modul eines weiteren Bereichs der Aufnahmeschicht verschieden ist, wobei der E-Modul zumindest in einem Bereich, in dem die Aufnahmeschicht das Werkstück überlagert, größer ist als in dem Anteil der Aufnahmeschicht, der die vorgegebene Form aufweist oder die Aufnahmeschicht derart behandelt wird, dass sie im vorbestimmten Bereich einen E-Modul aufweist, der gegenüber dem E-Modul eines weiteren Bereichs der Aufnahmeschicht verschieden ist, wobei der E-Modul zumindest in einem Bereich, in dem die Aufnahmeschicht das Werkstück überlagert, größer ist als in dem Formanteil der Aufnahmeschicht. Bevorzugt wird die Aufnahmeschicht zur Veränderung des E-Moduls lokal thermisch behandelt, insbesondere erwärmt oder abgekühlt. Diese Ausführungsform ist vorteilhaft, da sie eine zusätzliche oder alternative Möglichkeit darstellt den Rissverlauf im Werkstück und/oder einer Alblöseschicht zu beeinflussen bzw. reproduzierbar zu steuern.

Die Aufnahmeschicht zumindest zeitweise und zumindest abschnittsweise gemäß einer weiteren bevorzugten Ausführungsform der vorliegenden Erfindung an der Stabilisierungsschicht anhaftet und dass die Aufnahmeschicht zumindest zeitweise und zumindest abschnittsweise an der ersten exponierten Oberfläche des Werkstücks anhaftet, wobei der Grad der Haftung in zumindest einem Bereich zwischen der Aufnahmeschicht und der Stabilisierungsschicht und in zumindest einem Bereich zwischen der Aufnahmeschicht und der exponierten Oberfläche des Werkstücks derart unterschiedlich stark eingestellt wird, dass die Rissausbreitung innerhalb des Werkstücks definiert beeinflusst wird. Diese Ausführungsform ist vorteilhaft, da sie noch eine zusätzliche oder alternative Möglichkeit darstellt den Rissverlauf im Werkstück und/oder einer Alblöseschicht zu beeinflussen bzw. reproduzierbar zu steuern.

Gemäß einer weiteren bevorzugten Ausführungsform der vorliegenden Erfindung weist die Aufnahmeschicht in dem Bereich, in dem sie die erste exponierte Oberfläche des Werkstücks überlagert, eine durchschnittliche erste Dicke auf und der mindestens eine Formanteil der Aufnahmeschicht, weist eine durchschnittliche zweite Dicke auf, wobei die erste Dicke und die zweite Dicke derart verschieden sind, dass die Rissausbreitung innerhalb des Werkstücks definiert beeinflusst wird. Diese Ausführungsform ist vorteilhaft, da sie ebenfalls noch eine zusätzliche oder alternative Möglichkeit darstellt den Rissverlauf im Werkstück und/oder einer Alblöseschicht zu beeinflussen bzw. reproduzierbar zu steuern.

Die Dicke der Aufnahmeschicht verändert sich gemäß einer weiteren bevorzugten Ausführungsform der vorliegenden Erfindung in X-Richtung und/oder Y-Richtung bevorzugt konstant, wobei der Dickenunterschied im dünnsten Schichtbereich gegenüber dem dicksten Schichtbereich genau oder weniger als 5 mm und bevorzugt genau oder weniger als 3 mm und besonders bevorzugt genau oder weniger als 1 mm beträgt. Diese Ausführungsform ist vorteilhaft, da eine derartig ausgebildete Aufnahmeschicht zum einen günstig erzeugbar bzw. herstellbar ist und zum anderen einfach anwendbar ist.

Die Aufnahmeschicht gemäß einer weiteren bevorzugten Ausführungsform der vorliegenden Erfindung zumindest abschnittweise von einer Ablöseschicht überlagert bzw. benachbart wird und daran anhaftet, wobei die Ablöseschicht das Werkstück zumindest abschnittsweise in Umfangsrichtung umschließt und die Rissausbreitung außerhalb des Werkstücks beginnt und mittels der Ablöseschicht auf das Werkstück übertragen wird.

Das erfindungsgemäße Verfahren weist somit bevorzugt auch oder alternativ die folgenden Schritte auf: Zumindest abschnittsweises Überlagern der Aufnahmeschicht durch eine Ablöseschicht, wobei die Ablöseschicht bevorzugt zumindest abschnittsweise eine oder mehrere erste Grenzflächen mit der Aufnahmeschicht bildet, Verbinden der Aufnahmeschicht mit der exponierten Oberfläche des Werkstücks unter Bildung einer Kompositstruktur bzw. eines Laminats, wobei die Aufnahmeschicht zumindest abschnittsweise eine zweite Grenzfläche mit der exponierten Oberfläche des Werkstücks bildet, wobei diese zweite Grenzfläche bevorzugt durch einen Rand begrenzt wird, welcher zumindest abschnittsweise im Wesentlichen an einen Rand einer oder mindestens einer der einen oder mehreren ersten Grenzflächen angrenzt, und wobei die eine oder mindestens eine der einen oder mehreren ersten Grenzflächen und die zweite Grenzfläche zumindest abschnittsweise im Wesentlichen zueinander parallel ausgerichtet sind.

Gemäß dieser Ausführungsform wird die Ablöseschicht somit zeitlich mindestens bis kurz nach, bevorzugt bis mindestens eine Sekunde nach dem Ablösen der Festkörperschicht zumindest abschnittsweise entlang mindestens einer der einen oder mehreren ersten Grenzflächen von der Aufnahmeschicht nicht vollständig abgelöst, so dass die Ablöseschicht mit der Aufnahmeschicht nach dem Ablösen der Festkörperschicht zumindest abschnittsweise noch verbunden ist, bevorzugt in Abschnitten, wo ein Rand mindestens einer der einen oder mehreren ersten Grenzflächen zumindest abschnittsweise im Wesentlichen an einen Rand der zweiten Grenzfläche angrenzt. Sowohl die Abschnitte der einen oder mehreren ersten Grenzflächen, welche abgelöst werden, wie auch die Abschnitte, welche nicht vollständig abgelöst werden, können erfindungsgemäß in bestimmten vordefinierten Geometrien realisiert sein, wodurch die Dynamik und insbesondere der zeitliche Ablauf des Ablösens der Ablöseschicht von der Aufnahmeschicht und dadurch indirekt auch die Dynamik des Ablösens der Festkörperschicht bestimmt werden kann.

Ferner ist denkbar, dass die Aufnahmeschicht und/oder die Stabilisierungsschicht bezüglich der Ablöseschicht und/oder dem Werkstück zumindest abschnittsweise untermassig realisiert wird, d.h., die Aufnahmeschicht und/oder die Stabilisierungsschicht überdecken zumindest abschnittsweise die Ablöseschicht und/oder das Werkstück nicht vollständig.

Zusätzlich oder alternativ ist ebenfalls vorstellbar, dass die Aufnahmeschicht und/oder die Stabilisierungsschicht bezüglich der Ablöseschicht und/oder dem Werkstück zumindest abschnittsweise übermassig realisiert werden, d.h., es existieren zumindest abschnittsweise Bereiche in der Aufnahmeschicht und/oder der Stabilisierungsschicht, in denen weder ein Bereich des Werkstücks noch ein Bereich der Ablöseschicht überdeckt wird. Insbesondere in einem bevorzugten Ausführungsbeispiel, worin als Werkstück ein 4-inch, runder Germaniumwafer und als Ablöseschicht ein aus einem 6-inch pseudoquadratischen Siliziumwafer geschnittener Siliziumrahmen verwendet wird, ist es bevorzugt entlang einer geraden äußeren Kante des Siliziumrahmens jeweils einen Streifen der Aufnahmeschicht und der Stabilisierungsschicht mindestens 1mm, bevorzugt mindestens 1cm, über die Kante des Siliziumrahmens überstehen zu lassen, wobei die beiden Streifen einander besonders bevorzugt vollständig überdecken und miteinander verbunden sind.

Durch einen oder mehrere solche über den Rand des Werkstücks bzw. über den Rand der Ablöseschicht überstehenden Bereiche, wo Aufnahme- und Stabilisierungsschicht direkt miteinander verbunden sind, kann erreicht werden, dass die Bruchpropagation beim Ablösen der Festkörperschicht bzw. der Ablöseschicht an dieser Stelle stoppt oder sich verlangsamt, wodurch der zeitliche und räumliche Ablauf des gesamten Bruchs beeinflusst und damit z.B. nicht erwünschte Dickenschwankungen und Rauheiten auf der hergestellten Festkörperschicht reduziert werden können. Insbesondere kann durch eine "I" bzw. "L"- bzw. "U"-förmige Anordnung von einem bzw. zwei bzw. drei solcher entlang der entsprechenden geraden äußeren Kanten des pseudoquadratischen Siliziumrahmens überstehenden Bereiche der Bruchverlauf im Zentrum des Siliziumrahmens, d.h. im Bereich des Werkstücks, vorteilhaft beeinflusst werden, so dass die Dickenschwankungen der vom Werkstück abgelösten Festkörperschicht stark reduziert werden können. Außerdem kann in weiteren bevorzugten Ausführungsformen insbesondere in solchen überstehenden Bereichen die Haftung zwischen Aufnahme- und Stabilisierungsschicht lokal unterschiedlich gewählt werden, z.B. durch geeignete lokal unterschiedliche Behandlung der Schichtoberflächen oder Wahl der lokalen Geometrie, wodurch ebenfalls der zeitliche und räumliche Ablauf des Bruchs vorteilhaft beeinflusst werden kann.

In einer weiteren bevorzugten Ausführungsform steht die Aufnahmeschicht zumindest abschnittsweise in einem oder mehreren Bereichen über den Rand des Werkstücks über und überdeckt in diesen Bereichen zumindest abschnittsweise die Ablöseschicht und ist mit ihr verbunden. Durch geeignete Wahl der Geometrie dieser überstehenden Bereiche bzw. der vorgegeben Form dieses Anteils der Aufnahmeschicht und/oder der lokalen Haftung zwischen Aufnahmeschicht und Ablöseschicht in diesen Bereichen und/oder der lokalen Eigenschaften der Ablöseschicht wie insbesondere der Reißfestigkeit, kann erreicht werden, dass die Bruchpropagation beim Ablösen der Festkörperschicht an dieser Stelle stoppt oder sich verlangsamt, wodurch der zeitliche und räumliche Ablauf des gesamten Bruchs beeinflusst und damit z.B. nicht erwünschte Dickenschwankungen und Rauheiten auf der hergestellten Festkörperschicht reduziert werden können. Insbesondere kann durch eine "I" bzw. "L"- bzw. "U"-förmige Anordnung von einem bzw. zwei bzw. drei solcher entlang der entsprechenden bevorzugt geraden äußeren Kanten bevorzugt eines als Werkstück verwendeten 6-inch pseudoquadratischen Siliziumwafers überstehenden Bereiche der Bruchverlauf im Zentrum des Wafers vorteilhaft beeinflusst werden, so dass die Dickenschwankungen der vom Werkstück abgelösten Festkörperschicht dort stark reduziert werden können.

Gemäß einer weiteren bevorzugten Ausführungsform ist es bevorzugt, dass die Stabilisierungsschicht insbesondere im Fall von relativ dünnen, insbesondere weniger als 10mm dicken, Werkstücken und/oder Ablöseschichten die Aufnahmeschicht vollständig überdeckt.

Die zuvor beschriebenen Ausführungsbeispiele verwenden bevorzugt ein asymmetrisches Schichtsystem bestehend aus Metall-Polymer-Wafer/Ablöseschicht-Polymer, wobei die Polymerschicht zwischen Metall und Wafer/Ablöseschicht, welche zusammen mit der Metallschicht die Stabilisierungsschicht bildet, wesentlich dünner ist als diejenige Polymerschicht (die Aufnahmeschicht) auf der gegenüberliegenden Seite von Wafer/Ablöseschicht. Selbstverständlich kann das vorliegende Verfahren aber auch mit anderen Schichtsystemen angewandt werden, insbesondere symmetrische Schichtsysteme bestehend aus Metall-Polymer-Wafer-Polymer-Metall sowie Metall-Polymer-Wafer-Polymer-Wafer-Polymer-Metall sind bereits erfolgreich getestet worden.

Bevorzugt gilt unabhängig vom jeweiligen Ausführungsbeispiel bzw. der jeweiligen Ausführungsform, dass die benötigten Dicken und Materialeigenschaften (insbesondere Elastizitätsmodule) der verwendeten Aufnahmeschicht/en, insbesondere Polymerschicht/en, sowie der Stabilisierungsschicht/en, insbesondere der dort verwendeten Polymerschicht/en und Metallplatte/n, von den Dicken und Materialeigenschaften des Werkstücks abhängen sowie der gewünschten Zieldicke der abzuspaltenden Festkörperschicht, insbesondere des Wafers, abhängen. Beispielsweise wird gemäß einem Anwendungsbeispiel als Werkstück ein 400 Mikrometer dicker, <100> orientierter, runder Germaniumwafer mit 4-inch Durchmesser und als Ablöseschicht ein aus einem 400 Mikrometer dicken, <100> orientierten, 6-inch pseudoquadratischen Siliziumwafer geschnittener Siliziumrahmen verwendet, wobei sowohl der Germaniumwafer wie der Siliziumrahmen durch die Anwendung der vorliegenden Methode jeweils hälftig in zwei 200 Mikrometer dicke Wafer gespalten werden. Die dazu verwendeten Schichten im Schichtsystem haben bevorzugt die folgenden Dicken: Die Metallplatte in der Stabilisierungsschicht besteht bevorzugt aus Aluminium bzw. weist besonders bevorzugt Aluminium auf und ist bevorzugt zwischen 0,1 und 10 mm, insbesondere zwischen 0.5 und 5 mm dick, die Polymerschicht in der Stabilisierungsschicht ist bevorzugt zwischen 0,01 und 5 mm, insbesondere zwischen 0.02 und 1 mm dick, und die Aufnahmeschicht ist bevorzugt zwischen 0,1 und 20 mm, insbesondere zwischen 0.2 und 10 mm dick. Die seitlichen Abmessungen der Polymerschichten entsprechen bevorzugt jeweils denen des Siliziumrahmens, d.h. der Ablöseschicht, wobei bevorzugt gewisse Bereiche wie oben beschrieben über den äußeren Rand des Siliziumrahmens überstehen. Die seitlichen Abmessungen der Metallplatte sind bevorzugt etwas grösser, so dass diese relativ zum äußeren Rand des Siliziumrahmens gesehen z.B. jeweils ca. 2 cm vorsteht.

Gemäß einer weiteren bevorzugten Ausführungsform der vorliegenden Erfindung wird die Ablöseschicht, die aus einem weiteren Werkstück oder einem Opferwafer ausgebildet ist, infolge der Rissausbreitung zumindest abschnittsweise gespalten oder löst sich die Aufnahmeschicht infolge der Rissausbreitung von der Ablöseschicht ab bzw. die Aufnahmeschicht löst sich infolge einer Spannungseinleitung in die Kompositstruktur von der Ablöseschicht ab, wobei sich die ergebene Rissausbildung auf das Werkstück überträgt und in dem Werkstück fortsetzt
Diese Ausführungsform ist vorteilhaft, da sie ermöglicht, dass der Riss mittels der Ablöseschicht vormodulierbar ist bevor er auf das Werkstück übergeht.

Mehrere Werkstücke werden gemäß einer weiteren bevorzugten Ausführungsform der vorliegenden Erfindung derart angeordnet, sich infolge der Rissausbreitung der Riss von einem Werkstück auf ein anderes Werkstück derart überträgt, dass von jedem Werkstück (1) eine Festkörperschicht (5) abgetrennt wird. Diese Ausführungsform ist vorteilhaft, da die Rissführung verbessert wird und zeitgleich mehrere Festkörperschichten erzeugbar sind, wodurch die Herstellungsgeschwindigkeit deutlich ansteigt.

Der vorgegebene Formanteil weist gemäß einer weiteren bevorzugten Ausführungsform der vorliegenden Erfindung eine Ausdehnung in X- und Y-Richtung derart auf, die kleiner als ein Viertel und bevorzugt kleiner als ein Achtel und besonders bevorzugt kleiner als ein Sechzehntel oder Zweiunddreißigstel der Ausdehnung des Werkstücks in X- und Y-Richtung ist, um als Bremse der Rissausbreitung im Werkstück zu wirken. Diese Ausführungsform ist vorteilhaft, da durch die als Bremsen fungierenden Formanteile die Rissausbreitung definiert und wiederholbar steuerbar ist.

Die vorliegende Erfindung bezieht sich zudem auf eine Vorrichtung zur Herstellung von Festkörperschichten, insbesondere von Wafern. Die erfindungsgemäße Vorrichtung umfasst dabei mindestens eine Einrichtung zum Induzieren von definierten lokalen Spannungen in eine Kompositstruktur zum Abspalten einer Festkörperschicht von einem Werkstück, wobei das Werkstück zumindest zwei sich zueinander im Wesentlichen in parallelen X-Y-Ebenen erstreckende exponierte Oberflächen aufweist, eine Einrichtung zum Erzeugen und/oder Bereitstellen einer Stabilisierungsschicht zum Halten des Werkstücks, wobei die Stabilisierungsschicht zumindest abschnittsweise mit einer zweiten der beiden exponierten Oberflächen des Werkstücks und mit einer Aufnahmeschicht verbunden wird, eine Einrichtung zum Aufbringen oder Erzeugen der Aufnahmeschicht auf der ersten der beiden exponierten Oberflächen, wobei mindestens ein Anteil der Aufnahmeschicht in dem mit der Stabilisierungsschicht verbundenen Verbindungsbereich einen vorgegebenen Formanteil ausbildet, wobei der Formanteil im Verbindungsbereich derart ausgestaltbar ist, dass eine durch die Einrichtung zum Induzieren von definierten lokalen Spannungen bewirkbare Rissausbreitung innerhalb des Werkstücks definiert beeinflusst wird.

Weitere Vorteile, Ziele und Eigenschaften der vorliegenden Erfindung werden anhand nachfolgender Beschreibung anliegender Zeichnungen erläutert, in welchen beispielhaft erfindungsgemäße Wafer und Vorrichtungen dargestellt sind. Bauteile oder Elemente der erfindungsgemäßen Wafer und Vorrichtungen, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Einzelne oder alle Darstellungen der im Nachfolgenden beschriebenen Figuren sind bevorzugt als Konstruktionszeichnungen anzusehen, d.h. die sich aus der bzw. den Figuren ergebenden Abmessungen, Proportionen, Funktionszusammenhänge und/oder Anordnungen entsprechen bevorzugt genau oder bevorzugt im Wesentlichen denen der erfindungsgemäßen Vorrichtung. Der Gegenstand der Erfindung ist dabei durch die Ansprüche definiert.

Darin zeigen:
- Fig. 1a/b: Beispiele für erfindungsgemäße Schichtanordnungen;
- Fig. 2a/g: Beispiele für unterschiedlich ausgeprägte und angeordnete vordefinierte Anteile einer Aufnahmeschicht;
- Fig. 3a/c: Beispiele für die Anwendung des Erfindungskonzepts auf Multiwaferanordnungen;
- Fig. 4a/c: einen schematischen Ablauf einer im Sinne der vorliegenden Erfindung gesteuerten Rissausbreitung;
- Fig. 5a/b: Beispiele für Rissausbreitungen;
- Fig. 6a/b: weitere Beispiele für Rissausbreitungen;
- Fig. 7a/d: weitere Beispiele für Rissausbreitungen;
- Fig. 8a/f: weitere Beispiele für Rissausbreitungen;
- Fig. 9a/c: schematische Darstellungen von lokalen E-Modulmodifikationen;
- Fig. 10a/c: weitere schematische Darstellungen von lokalen E-Modulmodifikationen;
- Fig. 11a/d: schematische Darstellungen von bevorzugten Rissausbreitungsrichtungen;
- Fig. 12a/c: weitere schematische Darstellungen von bevorzugten Rissausbreitungsrichtungen;
- Fig. 13a/c: schematische Darstellungen der Abhängigkeit zwischen der Gestalt der Aufnahmeschicht und resultierenden Spannungslinien;
- Fig. 14a/c: schematische Darstellungen der Steuerbarkeit der Rissausbreitung mittels Stopp und/oder Bremse;
- Fig. 15a/b: weitere schematische Darstellungen der Steuerbarkeit der Rissausbreitung mittels Stopp und/oder Bremse;
- Fig. 16a/c: Fotos mit hervorgehobenen Risslinien bei unterschiedlichen Bremse/Stopp-Konfigurationen;
- Fig. 17a/c: weitere Fotos mit hervorgehobenen Risslinien bei unterschiedlichen Bremse/Stopp-Konfigurationen;
- Fig. 18a/b: Rissverläufe und zugehörige vergrößerte Darstellungen der Oberfläche der abgetrennten Festkörperschichten;
- Fig. 19a/c: vergrößerte Darstellungen typischer Oberflächenformen.

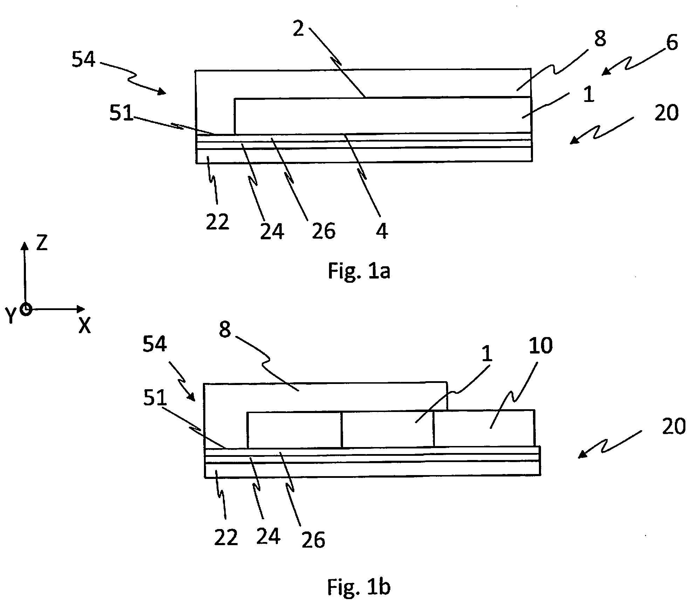

In Fig. 1a ist eine schematische Darstellung eines Schichtaufbaus gezeigt. Gemäß diesem Schichtaufbau wird eine zunächst exponierte Oberfläche 2 eines Werkstücks 1 von einer Aufnahmeschicht 8 bevorzugt vollständig und insbesondere anhaftend überlagert. Weiterhin weist das Werkstück 1 eine im Wesentlichen parallel zur ersten exponierten Oberfläche 2 ausgerichtete zweite Oberfläche 4 auf, die bevorzugt zunächst exponiert ist. Die zweite Oberfläche 4 wird dann bevorzugt von einer Stabilisierungsschicht 20, insbesondere anhaftend überlagert. Die Stabilisierungsschicht 20 kann dabei bevorzugt aus einer Polymerschicht, insbesondere PDMS, bestehen oder eine solche Polymerschicht aufweisen. Bevorzugt weist die Stabilisierungsschicht 20 jedoch eine Metallschicht 22 auf, auf der wiederum eine erste Polymerschicht 24, insbesondere aus PDMS, aufgebracht ist. Weiterhin ist auf der ersten Polymerschicht 24 bevorzugt eine zweite Polymerschicht 26 aufgebracht, welche die zweite exponierte Oberfläche 4 des Werkstücks 1 mit den zuvor genannten Anteilen der Stabilisierungsschicht 20 verbindet. Das Bezugszeichen 54 kennzeichnet einen überstehenden Anteil der Aufnahmeschicht 8, der über eine Verbindungsstelle 38 mit der Stabilisierungsschicht 20 verbunden ist.

In Fig. 1b ist eine Ausführungsform gezeigt, gemäß der die Aufnahmeschicht 8 das Werkstück 1 und/oder eine Ablöseschicht 10 nur teilweise bzw. abschnittsweise überlagert. Die Ablöseschicht 10 dient bevorzugt zur Einleitung eines Risses in das Werkstück 1. Bevorzugt kann die Ablöseschicht 10 hierbei aus einem Opfermaterial bestehen, das bei der Rissausbreitung ebenfalls gespalten wird. Die Aufnahmeschicht 8 kann jedoch ebenfalls derart ausgebildet sein, dass sie die Ablöseschicht 10 und/oder das Werkstück 1 vollständig überlagert und/oder vollständig umschließt.

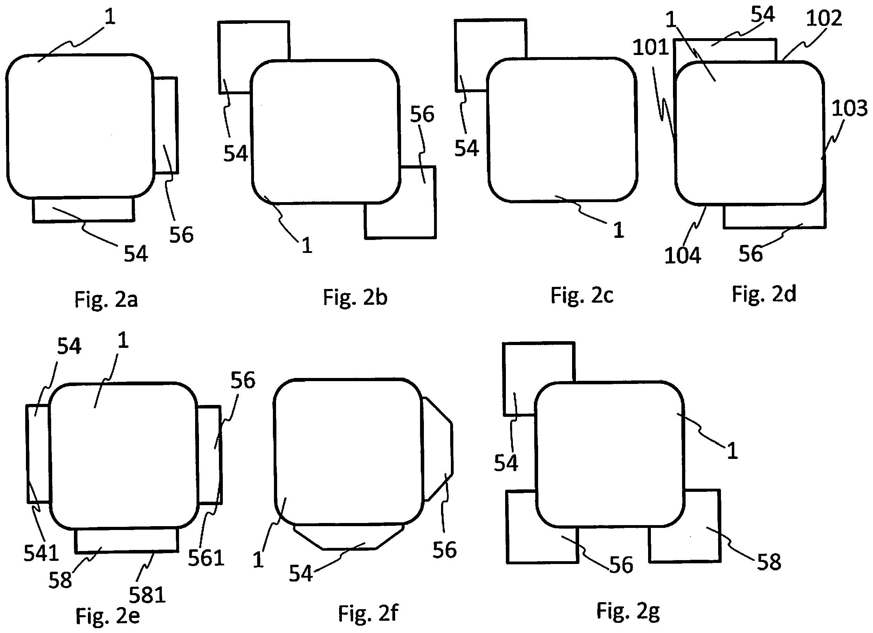

Die Figuren 2a bis 2g zeigen Draufsichten auf Mehrschichtanordnungen, wie sie beispielsweise in Bezug auf Fig. 1a/b beschrieben wurden. Es sind diesen Figuren Werkstücke 1 zu entnehmen, an deren Ränder definiert ausgebildete Anteile 54, 56, 58 der Aufnahmeschicht 8 überstehen. Die einzelnen Anteile 54, 56, 58 können hierbei je Werkstück 1 jeweils im Wesentlichen dieselbe Gestalt aufweisen, wobei ebenfalls denkbar ist, dass die Gestalt eines Anteils 54, von der Gestalt eines zweiten Anteils 56 und/oder von der Gestalt eines dritten Anteils 58 abweicht. Weiterhin ist ersichtlich, dass nur oder genau oder mindestens ein definierter Anteil 54 an einem Werkstück 1 ausgebildet sein kann, wobei bevorzugt genau oder mindestens zwei definierte Anteile 54, 56 oder genau oder mindestens drei definierte Anteile 54, 56, 58, insbesondere vier, fünf, sechs, sieben oder acht definierte Anteile, vorgesehen sein können.

In Fig. 2d ist sind vier sich in Umfangsrichtung des Werkstücks erstreckende Anteile 101, 102, 103, 104 der Außenkante des Werkstücks gekennzeichnet.

In Fig. 2e sind drei Außenkanten 541, 561, 581 der Aufnahmeschicht 8 gezeigt, an die sich jeweils ein definierter geometrischer Anteil zur Beeinflussung der Rissausbreitung anschließt.

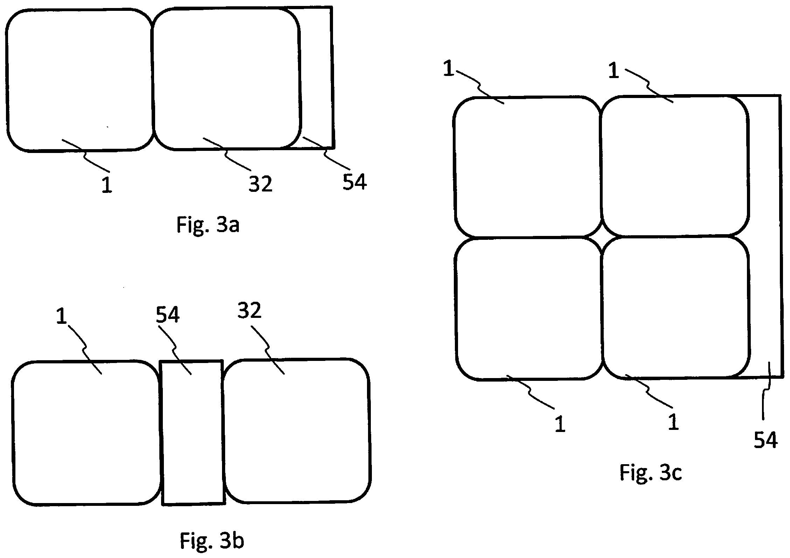

In den Figuren 3a-c sind verschiedene Anordnungen gezeigt, gemäß denen Festkörperschichten von mehreren Werkstücken 1 bzw. 32 abgelöst werden. Gemäß diesen Darstellungen kann z.B. ein definierter geometrischer Anteil 54 an einem Werkstück 1 (Fig. 3a) oder mehrere Werkstücke 1 miteinander verbindend (Fig. 3b und Fig. 3c) ausgebildet sein. Es ist jedoch ebenfalls denkbar, dass mehrere definierte geometrische Anteile 54, 56, 58 mit unterschiedlichen oder gleichen Formen an einer Multiwerkstückanordnung vorgesehen werden.

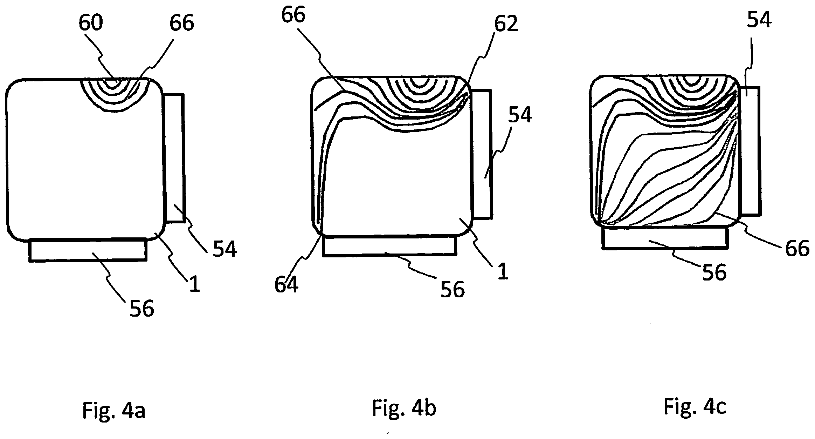

Durch die Figuren 4a-c werden mehrere Stufen einer Rissausbreitung gezeigt. Es wird durch diese Darstellung ersichtlich, dass mittels der erfindungsgemäßen Anordnung die Rissausbreitung beeinflussbar bzw. steuerbar ist, wodurch wiederholbar eine geringe Dickenvariation erzielbar ist.

In Fig. 4a kennzeichnet das Bezugszeichen 60 eine Stelle, an der die Rissausbreitung beginnt. Es ist jedoch ebenfalls denkbar, dass durch das Bezugszeichen 60 eine Linie gekennzeichnet wird, an der ein bereits mittels einer Ablöseschicht 10 geführter Riss auf das Werkstück 1 übergeht. Das Bezugszeichen 66 kennzeichnet hierbei Rissausbreitungslinien.

Der Fig. 4b lässt sich entnehmen, dass die Rissausbreitungslinien 66 durch den ersten definierten geometrischen Anteil 54 eine Rissausbreitungsbeeinflussung 2 erfahren.

Entsprechend bewegt sich das andere Ende der Rissausbreitung 66 bis zu einer durch den zweiten definierte geometrischen Anteil 56 bewirkten Rissausbreitungsbeeinflussung 64.

Fig. 4c zeigt, dass durch die definierten geometrischen Anteile 54, 56 eine im Wesentlichen diagonale Rissführung einstellbar ist.

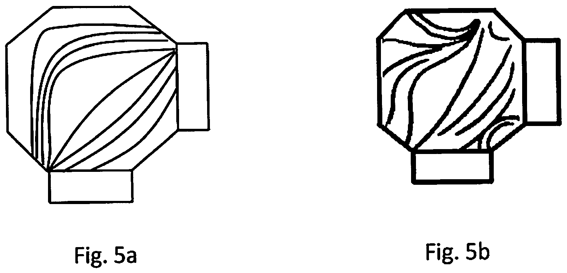

In den Figuren 5a und 5b sind Anordnungen gezeigt, gemäß denen ebenfalls eine diagonale Rissführung vorliegt. Weiterhin lässt sich diesen Figuren entnehmen, dass auch die Dicke der Aufnahmeschicht 8 Einflüsse auf die Rissausbreitung hat. Die Aufnahmeschicht 8 ist z.B. in dem in Fig. 5a gezeigten Beispiel dünner gewählt als in dem in der Fig. 5b gezeigten Beispiel, insbesondere weist die Dicke der Aufnahmeschicht 8 in der in Fig. 5a gezeigten Variante z.B. 2 mm und in der in Fig. 5b gezeigten Variante z.B. 3 mm auf.

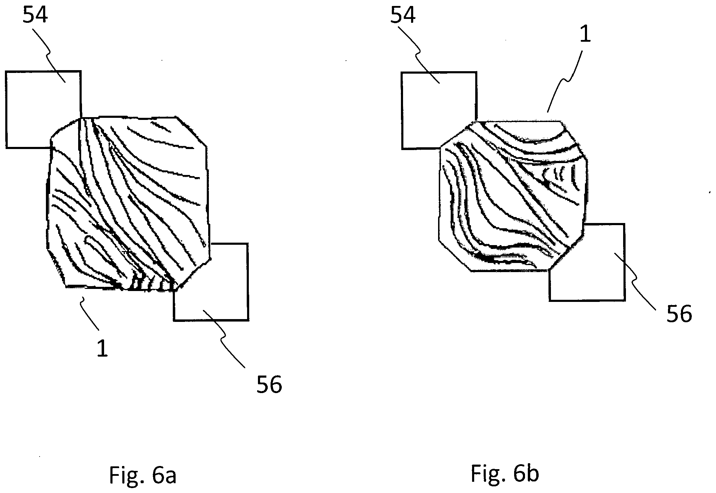

In den Figuren 6a/b sind die Risslinien von zwei gleich konfigurierten Werkstücken 1 gezeigt. Verwendung hat hierbei bevorzugt ein Klebechuck mit 2µm Wafer und eine 4mm Aufnahmeschicht 8, die bevorzugt als Folie ausgebildet ist. Es lässt sich dieser Darstellung entnehmen, dass die Rissmuster sehr ähnlich sind und dadurch einen reproduzierbaren Riss ermöglichen bzw. das reproduzierbare Abspalten von Festkörperschichten bei gleichbleibender Güte der Festkörperschichten ermöglichen.

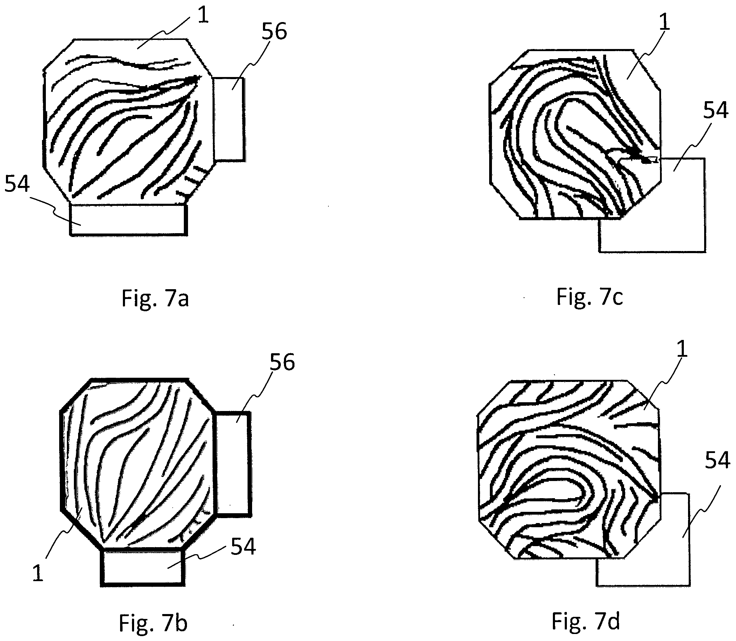

In den Fig. 7a/b und 7c/d sind ebenfalls die Rissverläufe gleich konfigurierter Werkstücke 1 gezeigt. Auch die daraus erzeugten Festkörperschichten weisen eine zueinander sehr ähnliche Oberfläche auf.

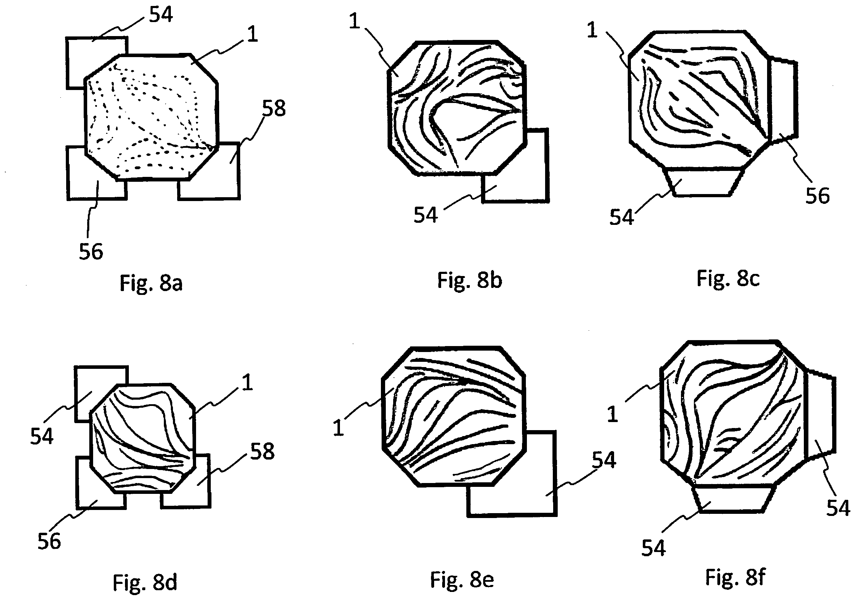

In den Figuren 8a-f sind jeweils zwei im Wesentlichen gleiche Anordnungen (8a und 8d; 8b und 8e; 8c und 8f) gezeigt. Die in der oberen Reihe gezeigten Rissverläufe ergeben sich bei der jeweiligen Anordnung der definierten geometrischen Anteile 54, 56, 58 bei Verwendung einer bevorzugt 2 mm dicken Aufnahmeschicht. Die in der unteren Reihe gezeigten Rissverläufe ergeben sich bei Verwendung einer bevorzugt 3 mm dicken Aufnahmeschicht 8. Es ist somit erkennbar, dass die Dicke der Aufnahmeschicht 8 als Parameter für die Steuerung der Rissausbreitung relevant ist.

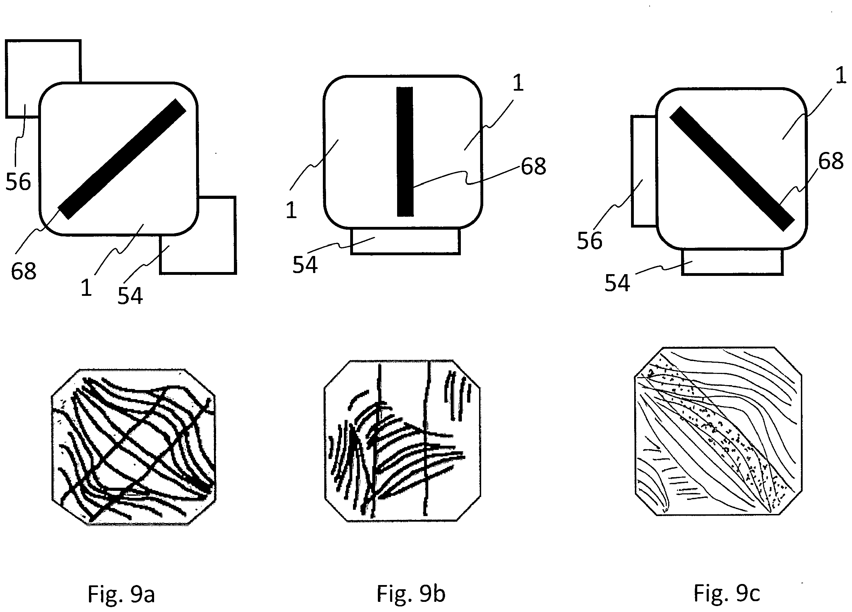

In den Figuren 9a-10c sind verschiedene Anordnungen von definierten geometrischen Anteilen 54, 56, 58 gezeigt. Weiterhin ist genau oder mindestens ein und bevorzugt sind zwei oder mehr mit dem Bezugszeichen 68 gekennzeichnete Felder je Werkstück 1 vorgesehen. Die Felder 68 kennzeichnen dabei bevorzugt Bereiche, in denen der E-Modul der Aufnahmeschicht 8 verschieden zu dem E-Modul der verbleibenden Aufnahmeschicht 8 ist. Der E-Modul in dem Feld 68 kann dabei z.B. durch eine bevorzugt zeitweilige, insbesondere 5 min bis 20 min und bevorzugt im Wesentlichen oder genau 10 min dauernde Temperierung verändert werden. Bevorzugt werden die Felder 68 mit einer Temperatur von 100°C bis 200°C und bevorzugt mit einer Temperatur von im Wesentlichen oder genau 150°C auf der Folienunterseite temperiert und zusätzlich oder alternativ mit einer Temperatur von 75°C bis 175°C und bevorzugt von im Wesentlichen oder genau 125°C auf der Folienoberseite temperiert. Die weiteren Bereiche der Aufnahmeschicht 8, d.h. die Bereiche, die nicht dem Feld 68 zuzurechnen sind, werden bevorzugt auf einer Temperatur unterhalb von 75°C und bevorzugt auf einer Temperatur von 40°C bis 60°C und besonders bevorzugt auf 50°C gehalten.

Unter den schematischen Darstellungen der Figuren 9a-10c, in denen auch das Feld mit dem veränderten E-Modul durch das Bezugszeichen 68 gekennzeichnet ist, sind Darstellungen der in der jeweiligen Konfiguration zu erwartenden Rissausbreitungslinien dargestellt.

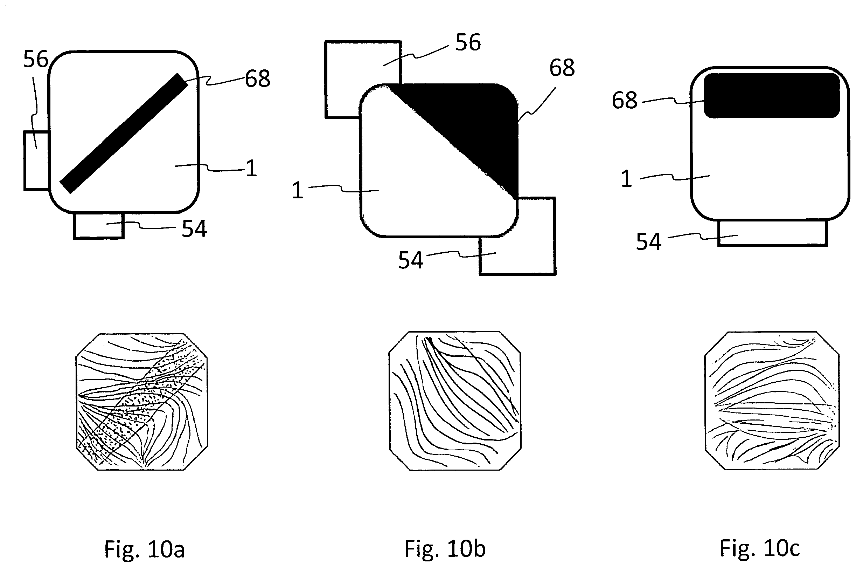

Das bzw. die Felder 68 modifizierten E-Moduls können sich dabei wie in den Fig. 9a, 9c und 10c gezeigt diagonal und/oder wie in den Figuren 9b und 10c gezeigt parallel zu einer Umfangskante des Werkstücks 1 bzw. der abgetrennten Festkörperschicht erstrecken. Ferner kann sich ein Feld 68 auch anteilig oder vollständig sphärisch, insbesondere rund oder oval, mehreckig, insbesondere dreieckig (vgl. Fig. 10b), viereckig, fünfeckig oder sechseckig, und/oder symmetrisch und/oder unsymmetrisch erstrecken.

Hinsichtlich der Ausbildung der definierten geometrischen Anteile 54, 56, 58 gilt das zu den vorigen und nachfolgenden Figuren ausgeführte.

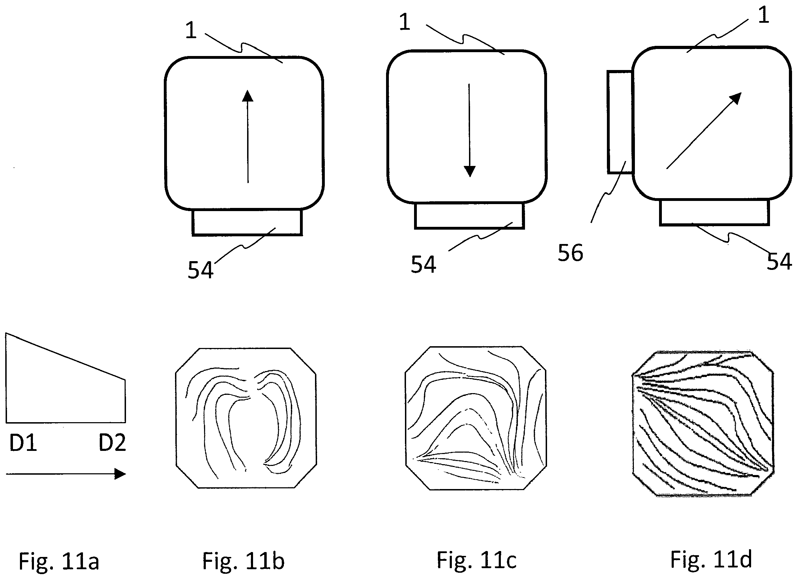

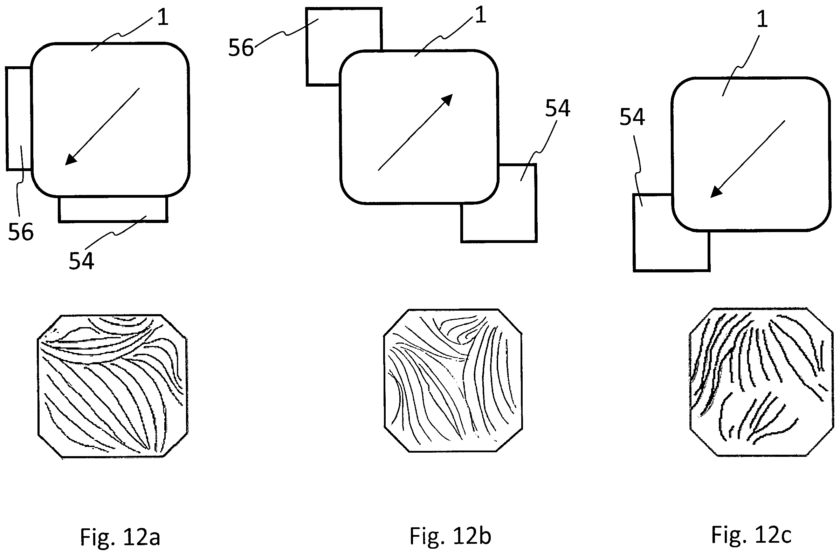

In den Figuren 11b-12c sind in der oberen Reihe jeweils schematische Anordnungen gezeigt, die ein, zwei, drei oder mehr definierte geometrische Anteile 54, 56, 58 aufweisen. Ferner sind in diesen schematischen Darstellungen Pfeile eingezeichnet. Diese Pfeile kennzeichnen (wie durch Fig. 11a gezeigt) die Richtung, in der sich die Dicke der Aufnahmeschicht 8 bevorzugt von einer Dicke D1 zu einer Dicke D2 hin verringert. Die Dickenverringerung erfolgt hierbei bevorzugt kontinuierlich bzw. linear, wobei ebenfalls denkbar ist, dass sich die Dicke der Aufnahmeschicht 8 in Stufen verändert. Bevorzugt ist die Dicke D1 eine Dicke im Bereich von 2 mm - 10 mm, insbesondere von genau 4 mm, und die Dicke D2 ist geringer als die Dicke D1 und liegt bevorzugt in einem Bereich von 1 mm - 9 mm.

In der unteren Reihe weisen die Figuren 11b-12c jeweils Darstellungen der in der jeweiligen Konfiguration zu erwartenden Rissausbreitungslinien auf.

Hinsichtlich der Ausbildung der definierten geometrischen Anteile 54, 56, 58 gilt das zu den vorigen und nachfolgenden Figuren ausgeführte.

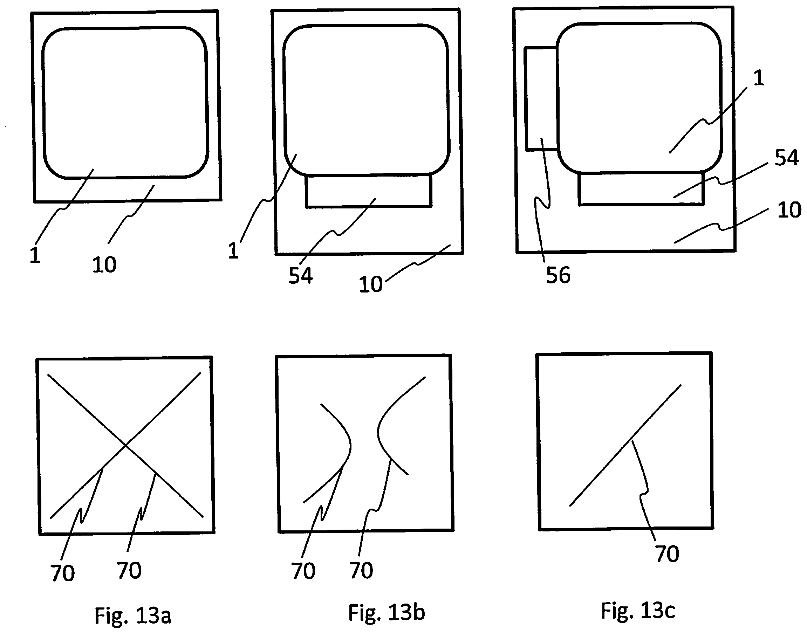

In den Figuren 13a bis 13c sind verschiedene typische Splitmuster dargestellt. In der oberen Reihe jeder Figur ist die Anordnung aus Werkstück 1 und Aufnahmeschicht 10 und evtl. vorgesehenen definierten geometrischen Abschnitten 54, 56 gezeigt. In der unteren Reihe sind die zugehörigen Spannungsmuster gezeigt.

Die in Fig. 13a gezeigte Anordnung stellt einen symmetrischen Split dar, wodurch sich die kreuzenden windmühlenartigen Spannungslinien 70 ergeben.

Die in Fig. 13b gezeigte Anordnung zeigt einen asymmetrischen Split, wobei die Anordnung einen definierten geometrischen Anteil 54 aufweist, wodurch sich zwei zueinander im Wesentlichen beabstandete Spannungskurven 70 ergeben.

In Fig. 13c ist ein weiterer asymmetrischer Split gezeigt, wobei das Werkstück 1 auf zwei Seiten definierte geometrische Anteile 54, 56 aufweist. Die sich aus dieser Anordnung ergebende Spannungsverteilung 70 ist schematisch als eine sich im Wesentlichen gerade erstreckende Linie darstellbar.

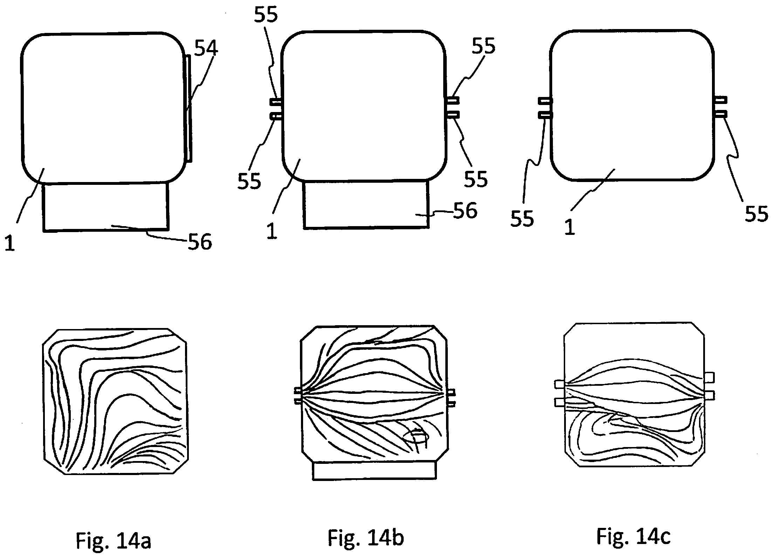

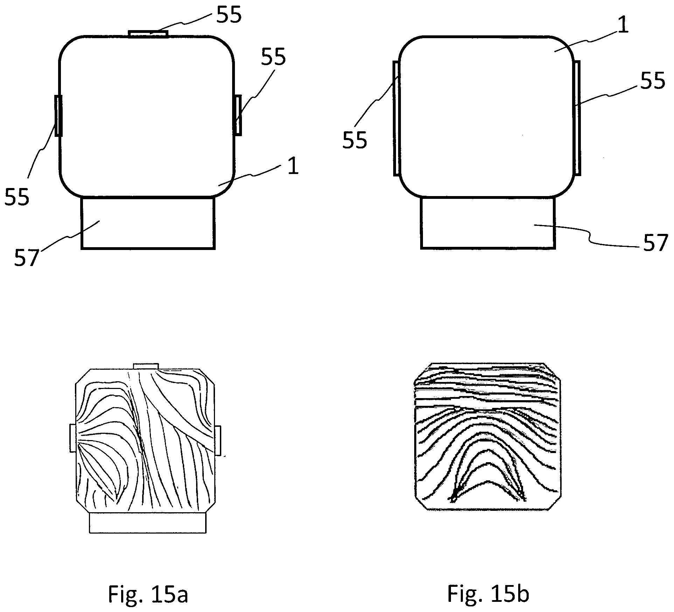

In den Figuren 14a-15b sind in der oberen Reihe jeweils Anordnungen gezeigt, bei denen das Werkstück 1 auf einer und bevorzugt auf zwei oder drei oder vier Seiten zumindest abschnittsweise von einem oder mehreren definierten geometrischen Anteilen 54, 56, 58 umgeben ist. Der erste definierte geometrische Anteil 54 stellt dabei bevorzugt eine Bremse 55 dar und der zweite definierte geometrische Anteil 56 stellt bevorzugt jeweils einen Stopp dar. In der unteren Reihe sind sich aus den einzelnen Anordnungen ergebende Rissverläufe zu entnehmen. Es ist somit erkennbar, welchen Einfluss unterschiedliche Anordnungen auf den Rissverlauf haben und dass der Rissverlauf über solche Anordnungen steuerbar ist.

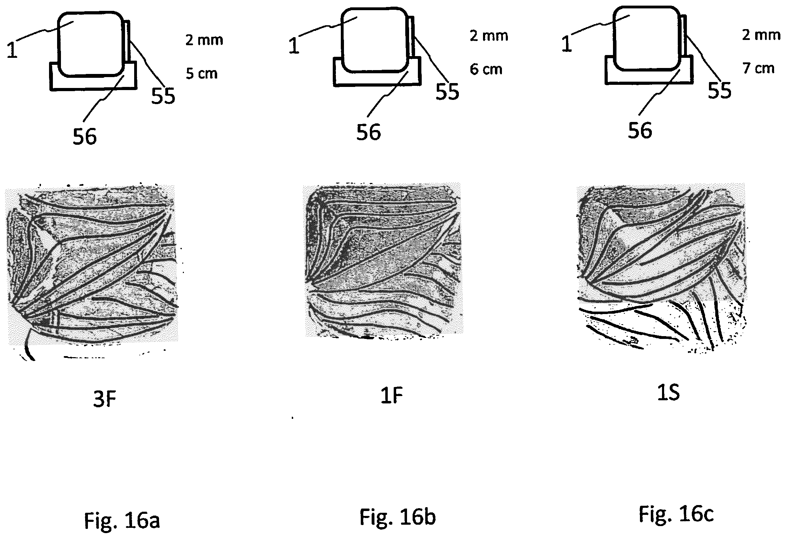

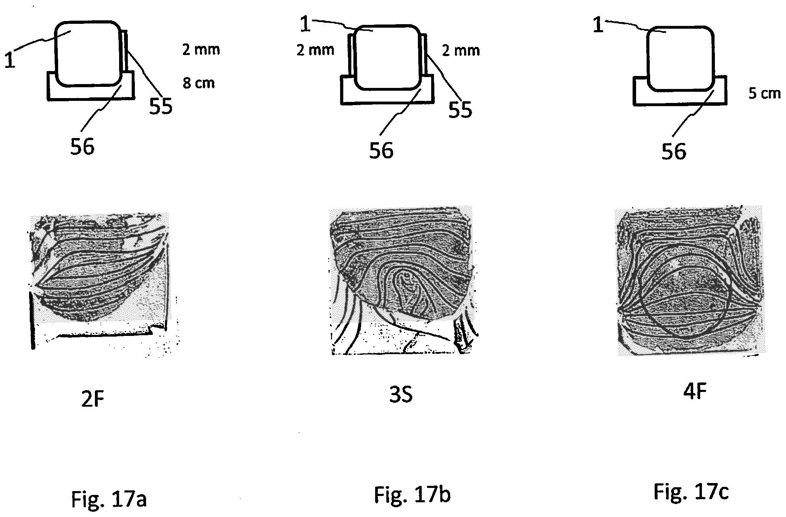

In den Figuren 16a-17c sind in der oberen Reihe unterschiedliche schematische Anordnungen gezeigt. Die Anordnungen unterscheiden sich im Wesentlichen durch die Anzahl und Gestalt der Bremsen 55 und die Gestalt des Stopps. Weiterhin sind die Anordnungen in unterschiedlichen Konfigurationen (3F, 1F, 1S, 2F, 3S, 4F) vorgesehen.

Die in der unteren Reihe gezeigten Darstellungen sind Fotografien der gesplitteten Werkstücke 1 mit eingezeichneten Rissverlaufslinien. Es ist diesen Darstellungen somit zu entnehmen, dass durch die Veränderung von bestimmten Parametern die Rissverläufe beeinflussbar bzw. steuerbar sind.

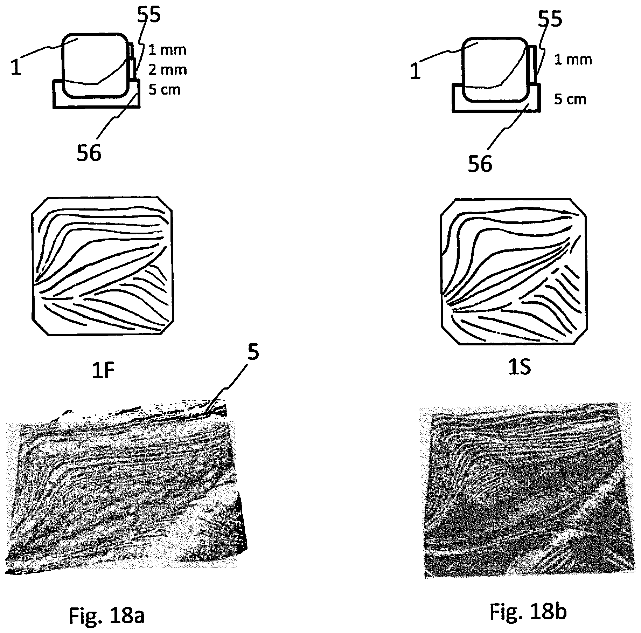

In der Fig. 18a ist in einer oberen Reihe eine schematische Anordnung gezeigt, die eine sich über eine Außenkante verändernde Form einer Bremse 55 zeigt. Es ist hierbei jedoch auch denkbar, dass nicht eine in der Gestalt über die Länge oder über einen Anteil der Länge einer Außenkante veränderte Bremse vorgesehen wird, sondern unterschiedlich gestaltete Bremsen 55 z.B. in Reihe hintereinander angeordnet werden.

In der mittleren Reihe der Fig. 18a sind Spannungslinien gezeigt, die beim Splitten auftreten.

In der unteren Reihe ist ein Vergrößerung der Oberfläche einer mittels der erfindungsgemäßen Splittechnik gesplitteten Festkörperschicht, insbesondere eines Wafers, gezeigt.

Analog hierzu zeigt die Fig. 18b eine weitere Anordnung mit sich dadurch ergebenden abweichenden Rissverläufen und einem dadurch abweichenden Oberflächenbild der gesplitteten Festkörperschicht.

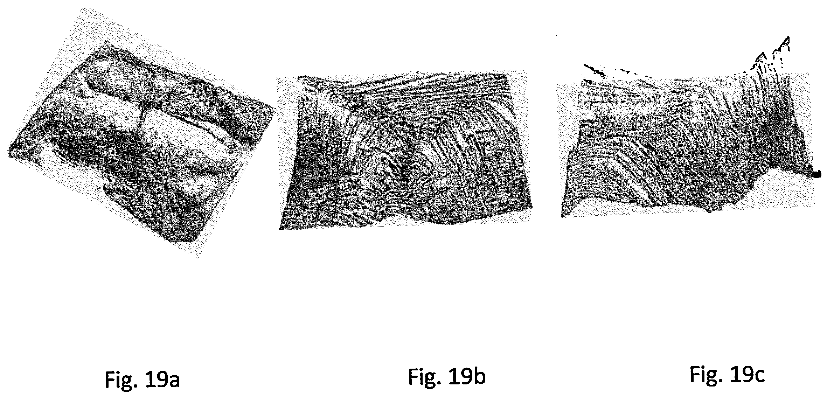

In Fig. 19a-19c sind hochaufgelöste Bilder unterschiedlicher Bruchmuster dargestellt. Das in Fig. 19a gezeigte Bruchmuster ergibt sich bei der in Fig. 13a gezeigten Anordnung und weist einen TTV von >150µm auf. Das in Fig. 19b gezeigte Bruchmuster ergibt sich bei der in Fig. 13b gezeigten Anordnung und weist einen TTV von etwa 120µm auf und das in Fig. 19c gezeigte Bruchmuster ergibt sich bei der in Fig. 13c gezeigten Anordnung und weist einen TTV von in etwa 100µm auf.

### Bezugszeichenliste

- 1.: Werkstück
- 2.: Exponierte Oberfläche
- 4.: Weitere exponierte Oberfläche
- 6.: Trägereinheit
- 8.: Aufnahmeschicht
- 10.: Ablöseschicht
- 20.: Stabilisierungsschicht
- 22.: Metallschicht
- 24.: Erste Polymerschicht
- 26.: Zweite Polymerschicht
- 32.: Weiteres Werkstück
- 38.: Verbindungsstelle
- 48.: Rissverlauf
- 51.: Verbindungsbereich
- 54.: erster definierter geometrischer Formanteil
- 55.: Formanteil (insbesondere Bremse)
- 56.: zweiter definierter geometrischer Anteil oder Zusatzanteil
- 58.: weiterer definierter geometrischer Anteil oder Zusatzanteil
- 60.: Start der Rissausbreitung
- 62.: erste Rissausbreitungsbeeinflussung
- 64.: zweite Rissausbreitungsbeeinflussung
- 66.: Rissausbreitungslinie
- 70.: Spannungslinie
- 101.: erste Außenkante des Werkstücks
- 102.: zweite Außenkante des Werkstücks
- 103.: dritte Außenkante des Werkstücks
- 104.: vierte Außenkante des Werkstücks
- 541.: erste Außenkante
- 561.: zweite Außenkante
- 581.: dritte Außenkante
- A: Schnitt
- X: erste Richtung
- Y: zweite Richtung
- Z: dritte Richtung

## Patentansprüche

1. Verfahren zur Herstellung von Festkörperschichten (5), insbesondere zur Verwendung als Wafer, mit den folgenden Schritten:
Bereitstellen mindestens eines Werkstücks (1) zum Ablösen der Festkörperschichten (5),
wobei das Werkstück (1) zumindest eine erste exponierte Oberflächen und eine zweite exponierte Oberfläche aufweist, wobei sich zumindest die erste exponierte Oberfläche in einer X-/Y-Ebene erstreckt.
Erzeugen und/oder Bereitstellen einer Aufnahmeschicht (8) zum Halten der Festkörperschicht (5),
zumindest abschnittsweises Verbinden der Aufnahmeschicht (8) mit der ersten exponierten Oberflächen (2) des Werkstücks (1) unter Bildung einer Kompositstruktur, und
Erzeugen und/oder Bereitstellen einer Stabilisierungsschicht (20) zum Halten des Werkstücks (1),
zumindest abschnittsweises Verbinden der Stabilisierungsschicht (20) mit der zweiten exponierten Oberflächen (4) des Werkstücks (1) und mit der Aufnahmeschicht (8) unter Bildung eines Verbindungsbereichs (51),
wobei mindestens ein Anteil (54, 55) der Aufnahmeschicht (8) in dem mit der Stabilisierungsschicht (20) verbundenen Verbindungsbereich (51) einen vorgegebenen Formanteil (54, 55) ausbildet,
Beaufschlagen der Kompositstruktur mit einem inneren und/oder äußeren Spannungsfeld in der Art, dass die Festkörperschicht (5) entlang einer sich innerhalb des Werkstücks (1) erstreckenden Ebene durch eine Rissausbreitung (48) von dem Werkstück (1) abgelöst wird, wobei durch den Formanteil (54, 55) die Rissausbreitung (48) innerhalb des Werkstücks (48) definiert beeinflusst wird.

2. Verfahren zur Herstellung von Festkörperschichten (5) nach Anspruch 1,
**dadurch gekennzeichnet, dass**
der mindestens eine Formanteil (54, 55) der Aufnahmeschicht (8) in der Rissausbreitungsebene angeordnet wird und in X- und/oder Y-Richtung zu der ersten Oberfläche (2) beabstandet angeordnet wird.

3. Verfahren zur Herstellung von Festkörperschichten (5) nach Anspruch 1 oder Anspruch 2,
**dadurch gekennzeichnet, dass**
die Aufnahmeschicht (8) eine erste Außenkante (541) und eine zweite Außenkante (561), die zueinander im Wesentlichen parallel ausgerichtet sind, und mindestens eine dritte Außenkanten (581), die gegenüber der ersten Außenkante (541) und der zweiten Außenkante (561) geneigt angeordnet ist, aufweist,
wobei die erste, zweite und dritte Außenkante (541, 561, 581) sich in einer X-Y-Ebene erstrecken und
an einer der drei Außenkanten (541) der Anteil der Aufnahmeschicht (8) mit dem vorgegebenen Formanteil (54, 55) ausgebildet ist und
an zumindest einer der beiden anderen Außenkanten (561, 581) ein Zusatzanteil (56, 58) zum Beeinflussen der Rissausbreitung mit einer vorgegebenen Form ausgebildet ist.

4. Verfahren zur Herstellung von Festkörperschichten (5) nach Anspruch 3,
**dadurch gekennzeichnet, dass**
an der zweiten Außenkante (561) und an der dritten Außenkante (581) jeweils ein separater Zusatzanteil (56, 58) zum Beeinflussen der Rissausbreitung mit einer vorgegebenen Form ausgebildet ist, wobei die an der ersten Außenkante (541), der zweiten Außenkante (561) und der dritten Außenkante (581) ausgebildeten Anteile (54, 56, 58) in ihrer Gesamtheit bevorzugt eine U-förmige Anordnung ausbilden.

5. Verfahren zur Herstellung von Festkörperschichten (5) nach einem der vorangegangenen Ansprüche,
**dadurch gekennzeichnet, dass**
innerhalb des Formanteils (54, 55) ein Strukturelement, insbesondere in Form eines Metallstücks, zur Veränderung der Eigenschaften des Formanteils (54, 55) in die Aufnahmeschicht (8) eingebracht ist, wobei das Strukturelement (10a) bevorzugt aus einem Material besteht, das von dem Material der Aufnahmeschicht (8) verschieden ist.

6. Verfahren zur Herstellung von Festkörperschichten (5) nach einem der vorangegangenen Ansprüche,
**dadurch gekennzeichnet, dass**
die Aufnahmeschicht (8) in einem vorbestimmten Bereich einen E-Modul aufweist, der gegenüber dem E-Modul mindestens eines weiteren Bereichs der Aufnahmeschicht (8) verschieden ist, wobei der E-Modul zumindest in einem Überlagerungsbereich, in dem die Aufnahmeschicht (8) das Werkstück (1) überlagert, größer ist als in dem Formanteil (54, 55), oder
die Aufnahmeschicht (8) derart behandelt wird, dass sie im vorbestimmten Bereich einen E-Modul aufweist, der gegenüber dem E-Modul eines weiteren Bereichs der Aufnahmeschicht (8) verschieden ist, wobei der E-Modul zumindest in einem Überlagerungsbereich, in dem die Aufnahmeschicht (8) das Werkstück (1) überlagert, größer ist als in dem Formanteil (54, 55).

7. Verfahren zur Herstellung von Festkörperschichten (5) nach einem der vorangegangenen Ansprüche,
**dadurch gekennzeichnet, dass**
die Aufnahmeschicht (8) zumindest zeitweise und zumindest abschnittsweise an der Stabilisierungsschicht (20) anhaftet und dass die Aufnahmeschicht (8) zumindest zeitweise und zumindest abschnittsweise an der ersten exponierten Oberfläche des Werkstücks (1) anhaftet, wobei der Grad der Haftung in zumindest einem Bereich zwischen der Aufnahmeschicht (8) und der Stabilisierungsschicht (20) und in zumindest einem Bereich zwischen der Aufnahmeschicht (8) und der exponierten Oberfläche des Werkstücks (1) derart unterschiedlich stark eingestellt wird, dass die Rissausbreitung (48) innerhalb des Werkstücks (1) definiert beeinflusst wird.

8. Verfahren zur Herstellung von Festkörperschichten (5) nach einem der vorangegangenen Ansprüche,
**dadurch gekennzeichnet, dass**
die Aufnahmeschicht (8) in dem Bereich, in dem sie die erste exponierte Oberfläche des Werkstücks (1) überlagert eine durchschnittliche erste Dicke aufweist und dass der mindestens eine Formanteil (54, 55) eine durchschnittliche zweite Dicke aufweist,
wobei die erste Dicke und die zweite Dicke derart verschieden sind, dass die Rissausbreitung (48) innerhalb des Werkstücks (1) definiert beeinflusst wird.

9. Verfahren zur Herstellung von Festkörperschichten (5) nach Anspruch 8,
**dadurch gekennzeichnet, dass**
sich die Dicke der Aufnahmeschicht (10) in X-Richtung und/oder Y-Richtung konstant verändert, wobei der Dickenunterschied im dünnsten Schichtbereich gegenüber dem dicksten Schichtbereich genau oder weniger als 5 mm und bevorzugt genau oder weniger als 3 mm und besonders bevorzugt genau oder weniger als 1 mm beträgt.

10. Verfahren zur Herstellung von Festkörperschichten (5) nach einem der vorangegangenen Ansprüche,
**dadurch gekennzeichnet, dass**
die Aufnahmeschicht (8) zumindest abschnittweise von einer Ablöseschicht (10) überlagert wird und daran anhaftet, wobei die Ablöseschicht (10) das Werkstück (1) zumindest abschnittsweise in Umfangsrichtung umschließt und die Rissausbreitung (48) außerhalb des Werkstücks (1) beginnt und mittels der Ablöseschicht (10) auf das Werkstück (1) übertragen wird.

11. Verfahren zur Herstellung von Festkörperschichten (5) nach Anspruch 10,
**dadurch gekennzeichnet, dass**
die Ablöseschicht (10) aus einem weiteren Werkstück (1) oder einem Opferwafer ausgebildet ist und infolge der Rissausbreitung (48) zumindest abschnittsweise gespalten wird.

12. Verfahren zur Herstellung von Festkörperschichten (5) nach Anspruch 10,
**dadurch gekennzeichnet, dass**
sich die Aufnahmeschicht (8) infolge einer Spannungseinleitung in die Kompositstruktur von der Ablöseschicht (10) ablöst, wobei sich die dadurch ergebene Rissausbildung auf das Werkstück (1) überträgt und in dem Werkstück (1) fortsetzt.

13. Verfahren zur Herstellung von Festkörperschichten (5) nach einem der vorangegangenen Ansprüche,
**dadurch gekennzeichnet, dass**
mehrere Werkstücke (1) derart angeordnet werden, dass sich infolge der Rissausbreitung der Riss von einem Werkstück auf ein anderes Werkstück derart überträgt, dass von jedem Werkstück (1) eine Festkörperschicht (5) abgetrennt wird.

14. Verfahren zur Herstellung von Festkörperschichten (5) nach einem der vorangegangenen Ansprüche,
**dadurch gekennzeichnet, dass**
der vorgegebene Formanteil (55) eine Ausdehnung in X- und Y-Richtung derart aufweist, die kleiner als ein Viertel und bevorzugt kleiner als ein Achtel und besonders bevorzugt kleiner als ein Sechzehntel der Ausdehnung des Werkstücks (1) in X- und Y-Richtung ist, um als Bremse der Rissausbreitung im Werkstück (1) zu wirken.

15. Vorrichtung zur Herstellung von Festkörperschichten (5), insbesondere von Wafern, mindestens umfassend
eine Einrichtung zum Induzieren von definierten lokalen Spannungen in eine Kompositstruktur zum Abspalten einer Festkörperschicht (5) von einem Werkstück (1),
wobei das Werkstück (1) zumindest zwei sich zueinander im Wesentlichen in parallelen X-Y-Ebenen erstreckende exponierte Oberflächen aufweist,
eine Einrichtung zum Erzeugen und/oder Bereitstellen einer Stabilisierungsschicht (20) zum Halten des Werkstücks (1), wobei die Stabilisierungsschicht (20) zumindest abschnittsweise mit einer zweiten der beiden exponierten Oberflächen (2) des Werkstücks (1) und mit einer Aufnahmeschicht (8) verbunden wird,
eine Einrichtung zum Aufbringen oder Erzeugen der Aufnahmeschicht (8) auf der ersten der beiden exponierten Oberflächen, wobei mindestens ein Anteil (54, 55) der Aufnahmeschicht (8) in dem mit der Stabilisierungsschicht (20) verbundenen Verbindungsbereich (51) einen vorgegebenen Formanteil (54, 55) ausbildet,
wobei der Formanteil (54, 55) im Verbindungsbereich (51) derart ausgestaltbar ist, dass eine durch die Einrichtung zum Induzieren von definierten lokalen Spannungen bewirkbare Rissausbreitung (48) innerhalb des Werkstücks (1) definiert beeinflusst wird.

## Claims

1. Method for producing solid-state layers (5), especially for use as wafers, having the following steps:
providing at least one workpiece (1) for detaching the solid-state layers (5),
where the workpiece (1) has at least one first exposed surface and one second exposed surface, where at least the first exposed surface extends in an X/Y plane,
generating and/or providing a receiving layer (8) for holding the solid-state layer (5),
joining at least sections of the receiving layer (8) to the first exposed surface (2) of the workpiece (1), to form a composite structure, and
generating and/or providing a stabilizing layer (20) for holding the workpiece (1),
joining sections at least of the stabilizing layer (20) to the second exposed surface (4) of the workpiece (1) and to the receiving layer (8), to form a joining region (51),
where at least a portion (54, 55) of the receiving layer (8) in the joining region (51) joined to the stabilizing layer (20) forms a specified shaping portion (54, 55),
subjecting the composite structure to an internal and/or external stress field in such a way that the solid-state layer (5) is detached from the workpiece (1) along a plane extending within the workpiece (1), by crack propagation (48), where the shaping portion (54, 55) exerts defined influence over the crack propagation (48) within the workpiece (48).

2. Method for producing solid-state layers (5) according to Claim 1,
**characterized in that**
the at least one shaping portion (54, 55) of the receiving layer (8) is disposed in the crack propagation plane and disposed at a distance from the first surface (2) in X and/or Y direction.

3. Method for producing solid-state layers (5) according to Claim 1 or Claim 2,
**characterized in that**
the receiving layer (8) has a first outer edge (541) and a second outer edge (561), which are aligned substantially parallel to one another, and at least a third outer edge (581), which is disposed at an inclination relative to the first outer edge (541) and the second outer edge (561),
where the first, second and third outer edges (541, 561, 581) extend in an X-Y plane and
the portion of the receiving layer (8) with the specified shaping portion (54, 55) is formed on one of the three outer edges (541) and
an ancillary portion (56, 58) for influencing the crack propagation with a specified shape is formed on at least one of the two other outer edges (561, 581).

4. Method for producing solid-state layers (5) according to Claim 3,
**characterized in that**
a separate ancillary portion (56, 58) for influencing the crack propagation with a specified shape is formed on each of the second outer edge (561) and the third outer edge (581), where the portions (54, 56, 58) formed on the first outer edge (541), the second outer edge (561) and the third outer edge (581) in their entirety preferably form a U-shaped arrangement.

5. Method for producing solid-state layers (5) according to any of the preceding claims,
**characterized in that**
within the shaping portion (54, 55) a structural element, more particularly in the form of a metal piece, is inserted into the receiving layer (8) for changing the properties of the shaping portion (54, 55), where the structural element (10a) consists preferably of a material which is different from the material of the receiving layer (8).

6. Method for producing solid-state layers (5) according to any of the preceding claims,
**characterized in that**
the receiving layer (8) in a predefined region has an elasticity modulus which is different from the elasticity modulus of at least one further region of the receiving layer (8), where the elasticity modulus at least in an overlying region, in which the receiving layer (8) overlies the workpiece (1), is greater than in the shaping portion (54, 55), or
the receiving layer (8) is treated in such a way that in the predefined region it has an elasticity modulus which is different from the elasticity modulus of one further region of the receiving layer (8), where the elasticity modulus at least in an overlying region, in which the receiving layer (8) overlies the workpiece (1), is greater than in the shaping portion (54, 55).

7. Method for producing solid-state layers (5) according to any of the preceding claims,
**characterized in that**
the receiving layer (8) adheres on the stabilizing layer (20) at least at times and at least in sections, and **in that** the receiving layer (8) adheres on the first exposed surface of the workpiece (1) at least at times and at least in sections, where the degree of the adherence established in at least one region between the receiving layer (8) and the stabilizing layer (20) and in at least one region between the receiving layer (8) and the exposed surface of the workpiece (1) is so different that the crack propagation (48) within the workpiece (1) is influenced in a defined way.

8. Method for producing solid-state layers (5) according to any of the preceding claims,
**characterized in that**
the receiving layer (8) in the region in which it overlies the first exposed surface of the workpiece (1) as an average first thickness, and **in that** the at least one shaping portion (54, 55) has an average second thickness,
where the first thickness and the second thickness are different in such a way that the crack propagation (48) within the workpiece (1) is influenced in a defined way.

9. Method for producing solid-state layers (5) according to Claim 8,
**characterized in that**
the thickness of the receiving layer (10) is changed constantly in X direction and/or Y direction, where the difference in thickness in the thinnest layer region relative to the thickest layer region is exactly or less than 5 mm and preferably exactly or less than 3 mm and more preferably exactly or less than 1 mm.

10. Method for producing solid-state layers (5) according to any of the preceding claims,
**characterized in that**
the receiving layer (8) at least in sections is overlaid by a detachment layer (10) and adheres thereto, where the detachment layer (10) surrounds the workpiece (1) at least in sections in the circumferential direction, and the crack propagation (48) begins outside the workpiece (1) and is transmitted to the workpiece (1) by means of the detachment layer (10).

11. Method for producing solid-state layers (5) according to Claim 10,
**characterized in that**
the detachment layer (10) is formed of a further workpiece (1) or of a sacrificial wafer and is split at least in sections as a result of the crack propagation (48).

12. Method for producing solid-state layers (5) according to Claim 10,
**characterized in that**
the receiving layer (8) detaches from the detachment layer (10) as a result of introduction of stress into the composite structure, where the resultant cracking transfers to the workpiece (1) and continues in the workpiece (1).

13. Method for producing solid-state layers (5) according to any of the preceding claims,
**characterized in that**
a plurality of workpieces (1) are disposed in such a way that as a result of the crack propagation, the crack transfers from one workpiece to another workpiece in such a way that a solid-state layer (5) is removed from each workpiece (1).

14. Method for producing solid-state layers (5) according to any of the preceding claims,
**characterized in that**
the specified shaping portion (55) has an extent in X and Y direction which is less than a quarter and preferably less than an eighth and more preferably less than a sixteenth of the extent of the workpiece (1) in X and Y direction, in order to act as a brake on the crack propagation in the workpiece (1).

15. Apparatus for producing solid-state layers (5), especially wafers, at least comprising
a device for inducing defined local stresses in a composite structure for splitting off a solid-state layer (5) from a workpiece (1),
where the workpiece (1) has at least two exposed surfaces extending substantially in parallel X-Y planes to one another,
a device for generating and/or providing a stabilizing layer (20) for holding the workpiece (1), where the stabilizing layer (20) is joined at least in sections to a second of the two exposed surfaces (2) of the workpiece (1) and to a receiving layer (8),
a device for applying or generating the receiving layer (8) on the first of the two exposed surfaces, where at least a portion (54, 55) of the receiving layer (8) in the joining region (51) joined to the stabilizing layer (20) forms a specified shaping portion (54, 55),
where the shaping portion (54, 55) in the joining region (51) is configurable in such a way that a crack propagation (48), which can be brought about by the device for inducing defined local stresses, within the workpiece (1) is influenced in a defined way.

## Revendications

1. Procédé de fabrication de couches (5) semi-conductrices, à utiliser notamment comme plaquettes, comprenant les stades suivants :
on se procure au moins une pièce (1) pour détacher des couches (5) semi-conductrices,
la pièce (1) ayant au moins une première surface à découvert et une deuxième surface à découvert, au moins la première surface à découvert s'étendant dans un plan X/Y,
on produit et/ou on se procure une couche (8) de réception pour le maintien de la couche (5) semi-conductrice,
on relie, au moins par endroits, la couche (8) de réception à la première surface (2) à découvert de la pièce (1), en formant une structure composite, et
on produit et/ou on se procure une couche (2) de stabilisation pour le maintien de la pièce (1),
on relie, au moins par endroits, la couche (20) de stabilisation à la deuxième surface (4) à découvert de la pièce (1) et à la couche (8) de réception, en formant une région (51) de liaison,
dans lequel au moins une partie (54, 55) de la couche (8) de réception constitue, dans la région (51) de liaison reliée à la couche (20) de stabilisation, une partie (54, 55) de forme donnée à l'avance,
on soumet la structure composite à un champ intérieur et/ou extérieur de contrainte, de manière à ce que la couche (5) semi-conductrice se détache de la pièce (1) par une propagation (48) de fissure le long d'un plan s'étendant au sein de la pièce (1), la propagation (48) de fissure au sein de la pièce (48) étant influencée de manière définie par la partie (54, 55) de forme.

2. Procédé de fabrication de couches (5) semi-conductrices suivant la revendication 1,
**caractérisé en ce que** l'on met la au moins une partie (54, 55) de forme de la couche (8) de réception dans le plan de propagation de la fissure et/ou on la met à distance dans la direction X et/ou dans la direction Y de la première surface (2).

3. Procédé de fabrication de couches (5) semi-conductrices suivant la revendication 1 ou la revendication 2,
**caractérisé en ce que**
la couche (8) de réception a un premier bord (541) extérieur et un deuxième bord (561) extérieur, qui sont sensiblement parallèles l'un à l'autre, et au moins un troisième bord (581) extérieur, qui est incliné par rapport au premier bord (541) extérieur et au deuxième bord (561) extérieur,
les premier, deuxième et troisième bords (541, 561, 581) extérieurs s'étendant dans un plan X-Y et
sur l'un des trois bords (541) extérieurs est constituée la partie de la couche (8) de réception ayant la partie (54, 55) de forme donnée à l'avance et
sur au moins l'un des deux autres bords (561, 581) extérieurs est constituée une partie (56, 58) supplémentaire pour influencer la propagation de la fissure par une forme donnée à l'avance.

4. Procédé de fabrication de couches (5) semi-conductrices suivant la revendication 3,
**caractérisé en ce que**,
sur le deuxième bord (561) extérieur et sur le troisième bord (581) extérieur est constituée, respectivement, une partie (56, 58) supplémentaire distincte pour influencer la propagation de la fissure par une forme donnée à l'avance, les parties (54, 56, 58), constituées sur le premier bord (541) extérieur, le deuxième bord (561) extérieur et le troisième bord (581) extérieur, constituant dans leur ensemble de préférence un agencement en forme de U.

5. Procédé de fabrication de couches (5) semi-conductrices suivant l'une des revendications précédentes,
**caractérisé en ce qu'**
au sein de la partie (54, 55) de forme, un élément de structure, notamment sous la forme d'une pièce métallique, est introduit dans la couche (8) de réception pour modifier les propriétés de la partie (54, 55) de forme, l'élément (10a) de structure étant de préférence en un métal, qui est différent du matériau de la couche (8) de réception.

6. Procédé de fabrication de couches (5) semi-conductrices suivant l'une des revendications précédentes,
**caractérisé en ce que**
la couche (8) de réception a, dans une région déterminée à l'avance, un module E, qui est différent du module E d'au moins une autre région de la couche (8) de réception, le module E, au moins dans une région de superposition dans laquelle la couche (8) de réception est superposée à la pièce (1), étant plus grand que dans la partie (54, 55) de forme ou
on traite la couche (8) de réception de manière à ce qu'elle ait, dans une région déterminée à l'avance, un module E, qui est différent du module E d'une autre région de la couche (8) de réception, le module E, au moins dans une région de superposition, dans laquelle la couche (8) de réception est superposée à la pièce (1), étant plus grand que dans la partie (54, 55) de forme.

7. Procédé de fabrication de couches (5) semi-conductrices suivant l'une des revendications précédentes,
**caractérisé en ce que**
la couche (8) de réception adhère, au moins de temps en temps et au moins par endroits, à la couche (20) de stabilisation et **en ce que** la couche (8) de réception adhère, au moins de temps en temps et au moins par endroits, à la première surface à découvert de la pièce (1), le degré d'adhérence, dans au moins une région entre la couche (8) de réception et la couche (20) de stabilisation et dans au moins une région entre la couche (8) de réception et la surface à découvert de la pièce (1), étant réglé de manière très différente, de manière à influencer de manière définie la propagation (48) de la fissure au sein de la pièce (1).

8. Procédé de fabrication de couches (5) semi-conductrices suivant l'une des revendications précédentes,
**caractérisé en ce que**
la couche (8) de réception a, dans la région dans laquelle elle est superposée à la première surface à découvert de la pièce (1), une première épaisseur moyenne et **en ce que** la au moins une partie (54, 55) de forme a une deuxième épaisseur moyenne,
la première épaisseur et la deuxième épaisseur étant différente de manière à influencer de manière définie la propagation (48) de la fissure au sein de la pièce (1).

9. Procédé de fabrication de couches (5) semi-conductrices suivant la revendication 8,
**caractérisé en ce que**
l'épaisseur de la couche (10) de réception se modifie de manière constante dans la direction X et/ou dans la direction Y, la différence d'épaisseur, dans la région la plus mince de la couche, par rapport à la région la plus épaisse de la couche, étant exactement ou de moins de 5 mm et, de préférence, exactement ou de moins de 3 mm, et, d'une manière particulièrement préférée, exactement ou de moins de 1 mm.

10. Procédé de fabrication de couches (5) semi-conductrices suivant l'une des revendications précédentes,
**caractérisé en ce que**
l'on superpose la couche (8) de réception, au moins par endroits, à une couche (10) de détachement et on l'y colle, la couche (10) de détachement entourant la pièce (1), au moins par endroits, dans la direction du pourtour et la propagation (48) de la fissure commence à l'extérieur de la pièce (1) et se transmet à la pièce (1) au moyen de la couche (10) de détachement.

11. Procédé de fabrication de couches (5) semi-conductrices suivant la revendication 10,
**caractérisé en ce que**
la couche (10) de détachement est constituée d'une autre pièce (1) ou d'une plaquette sacrificielle et est séparée, au moins par endroits, en raison de la propagation (48) de la fissure.

12. Procédé de fabrication de couches (5) semi-conductrices suivant la revendication 10,
**caractérisé en ce que**
la couche (8) de réception se détache de la couche (10) de détachement en raison d'une application d'une contrainte à la structure composite, la propagation de la fissure ainsi créée se transmettant à la pièce (1) et se continuant dans la pièce (1).

13. Procédé de fabrication de couches (5) semi-conductrices suivant l'une des revendications précédentes,
**caractérisé en ce que**
l'on dispose plusieurs pièces (1) de manière à ce que, en raison de la propagation de la fissure, la fissure se transmet d'une pièce à une autre pièce, **en ce que** l'on sépare une couche (5) semi-conductrice de chaque pièce (1).

14. Procédé de fabrication de couches (5) semi-conductrices suivant l'une des revendications précédentes,
**caractérisé en ce que**
la partie (55) de forme donnée à l'avance a une étendue dans la direction X et Y, qui est plus petite qu'un quart et, de préférence, plus petite qu'un huitième, et, d'une manière particulièrement préférée, plus petite qu'un seizième de l'étendue de la pièce (1) dans la direction X et Y, afin d'agir comme frein de la propagation de la fissure dans la pièce (1).

15. Installation de fabrication de couches (5) semi-conductrices, notamment de plaquettes, comprenant au moins
un dispositif pour induire des contraintes locales définies dans une structure composite pour séparer une couche (5) semi-conductrice d'une pièce (1),
la pièce (1) ayant au moins deux surfaces à découvert s'étendant l'une par rapport à l'autre dans des plans X-Y sensiblement parallèles,
un dispositif de production et/ou de mise à dispositif d'une couche (20) de stabilisation pour maintenir la pièce (1), la couche (20) de stabilisation étant reliée, au moins par endroits, à une deuxième des deux surfaces (2) à découvert de la pièce (1) et à une couche (8) de réception, et
un dispositif de dépôt ou de production de la couche (8) de réception sur la première des deux surfaces à découvert, au moins une partie (54, 55) de la couche (8) de réception constituant une partie (54, 55) de forme donnée à l'avance dans la région (51) de liaison reliée à la couche (20) de stabilisation,
dans laquelle la partie (54, 55) de forme peut être conformée dans la région (51) de liaison, de manière à ce qu'une propagation (48) de fissure, pouvant être provoquée par le dispositif pour induire des contrainte locales définies, soit influencée d'une manière définie au sein de la pièce (1).
